# EUROPEAN PATENT APPLICATION

(11) **EP 4 802 928 A1**
(43) Date of publication of application: **09.09.2026**
(21) Application number: 24886108.0
(22) Date of filing: 22.10.2024
(51) Int. Cl.: A24F 40/46, A24F 40/50, A24F 40/51, A24F 40/42, G01R 27/26, H05B 3/00

(54) **AEROSOL GENERATION DEVICE**

(30) Priority: 31.10.2023 KR 20230148425; 18.01.2024 KR 20240008291
(71) Applicant: KT&G Corporation, Daedeok-gu Daejeon 34337 (KR)
(72) Inventor: KWON, Young Bum, Yongin-si, Gyeonggi-do 16930 (KR); KIM, Dong Sung, Seoul 06310 (KR); KIM, Yong Hwan, Gyeonggi-do 13970 (KR); AN, Hwi Kyeong, Seoul 02721 (KR)
(74) Representative: Ter Meer Steinmeister & Partner
(86) International application number: PCT/KR2024/016041
(87) International publication number: WO 2025/095433

(57) **Abstract**

An aerosol-generating device includes a housing including an accommodation space for accommodating an aerosol-generating article, and a heater positioned inside the housing, and configured to heat an aerosol-generating article accommodated in the accommodation space when power is supplied, wherein the heater includes a polyimide film arranged to surround an aerosol-generating article accommodated in the accommodation space, a conductive pattern arranged on the polyimide film and configured to generate heat when power is supplied, and a sensing pad arranged so as not to overlap the conductive pattern, and configured to detect capacitance of the accommodation space.

## Description

### Technical Field

Embodiments relate to an aerosol-generating device including a sensing pad positioned so as not to overlap a conductive pad on a polyimide film.

### Background Art

In recent years, there has been an increasing demand for alternative methods that overcome the disadvantages of existing cigarettes. For example, there has been a growing demand for a system that generates an aerosol by heating a cigarette or an aerosol-generating material by using an aerosol-generating device, rather than by burning a cigarette. Accordingly, research on heating-type aerosol-generating devices has been actively conducted.

In order to shorten the user's smoking time and improve convenience, the aerosol-generating device may detect whether a cigarette is accommodated inside the aerosol-generating device through a sensor, and if it is confirmed that a cigarette is accommodated, power may be supplied to a heater to preheat the cigarette. In addition, in order to prevent excessively high-temperature aerosol from being supplied to the user, the aerosol-generating device may detect whether a cigarette is overly moistened and, according to the over-moisture state of the cigarette, control the temperature at which the cigarette is heated.

### Disclosure of Invention

### Technical Problem

In existing aerosol-generating devices, there is a limitation in miniaturizing the overall sizes of the aerosol-generating devices because they additionally require a space for a sensor to be placed to detect whether a cigarette is accommodated or overly moistened, or a configuration (e.g., a separate layer) in which the sensor may be mounted.

In addition, in the existing aerosol-generating devices, because the sensor is placed a certain distance away from an accommodation space where the cigarette is accommodated, it is difficult to precisely detect a change (e.g., a change in capacitance) in the characteristics of the accommodation space depending on whether the cigarette is accommodated or the over-moisture of the cigarette.

When a change in the characteristics of the accommodation space is not precisely detected, a heater may be operated even though the cigarette is not accommodated due to a misjudgment of whether the cigarette is accommodated or the over-moisture of the cigarette may be incorrectly judged, resulting in a situation where the cigarette is not heated to a specified temperature. Therefore, there is a need for a method for improving the precision of the sensor while promoting miniaturization of the aerosol-generating device.

Various embodiments of the present disclosure provide an aerosol-generating device that may more precisely detect whether a cigarette is accommodated or the over-moisture of the cigarette without adding a separate configuration through a structure in which a sensor for detecting whether the cigarette is accommodated or the over-moisture of the cigarette is placed within a heater.

The technical problems of the present disclosure are not limited to the above-described description, and other technical problems may be clearly understood by one of ordinary skill in the art from the embodiments to be described hereinafter.

### Solution to Problem

An aerosol-generating device according to an embodiment may include a housing including an accommodation space for accommodating an aerosol-generating article, and a heater positioned inside the housing and configured to heat an aerosol-generating article accommodated in the accommodation space when power is supplied, wherein the heater includes a polyimide film arranged to surround an aerosol-generating article accommodated in the accommodation space, a conductive pattern arranged on the polyimide film and configured to generate heat when the power is supplied, and a sensing pad arranged so as not to overlap the conductive pattern and configured to detect capacitance of the accommodation space.

### Advantageous Effects of Invention

An aerosol-generating device according to various embodiments of the present disclosure may detect the capacitance of an accommodation space without adding a separate configuration for a sensing pad to be placed.

In addition, the aerosol-generating device according to various embodiments of the present disclosure may more accurately measure the capacitance of the accommodation space, and thus may precisely detect whether an aerosol-generating article is accommodated or whether the aerosol-generating article is overly moist.

However, effects of the embodiments are not limited to the above-described effects, and effects not mentioned may be clearly understood by one of ordinary skill in the art to which the embodiments

### Brief Description of Drawings

FIG. 1 is a perspective view illustrating an aerosol-generating device of an embodiment.
FIG.2 is a view showing a partial cross-section of the aerosol-generating device illustrated in FIG.1.
FIG. 3 is an exploded perspective view showing a heater, a fixing member and an insulating member of an aerosol-generating device according to an embodiment.
FIG. 4 is a view showing the arrangement structure of components of a heater in a state in which a polyimide film is unfolded, according to an embodiment.
FIG. 5 is a view for explaining a process of rolling the polyimide film shown in FIG. 4.
FIG. 6 is a perspective view showing components of a heater when the polyimide film shown in FIG. 5 is completely rolled.
FIG. 7 is a perspective view showing a protective sheet for surrounding the outer surface of a polyimide film, according to another embodiment.
FIG. 8 block diagram showing some components of an aerosol-generating device of an embodiment.
FIG. 9 flowchart for explaining a control operation based on a capacitance value of an accommodation space detected through a sensing pad of an aerosol-generating device of an embodiment.
FIG. 10 is a block diagram of an aerosol-generating device according to an embodiment.

### Mode for the Invention

Regarding the terms in the various embodiments, the general terms which are currently and widely used are selected in consideration of functions of structural elements in the various embodiments of the present disclosure. However, meanings of the terms can be changed according to intention, a judicial precedence, the appearance of a new technology, and the like. In addition, in certain cases, terms which can be arbitrarily selected by the applicant in particular cases. In such a case, the meaning of the terms will be described in detail at the corresponding portion in the description of the present disclosure. Therefore, the terms used in the various embodiments of the present disclosure should be defined based on the meanings of the terms and the descriptions provided herein.

In addition, unless explicitly described to the contrary, the word "comprise" and variations such as "comprises" or "comprising" will be understood to imply the inclusion of stated elements but not the exclusion of any other elements. In addition, the terms "-er", "-or", and "module" described in the specification mean units for processing at least one function and operation and can be implemented by hardware components or software components and combinations thereof.

In addition, when describing the embodiments of the disclosure, the detailed description of the related known art, which may obscure the subject matter of the embodiments, may be omitted. Also, the accompanying drawings are only intended to facilitate understanding of the embodiments described herein, and the spirit of the disclosure is not limited by the accompanying drawings and should be understood to include all changes, equivalents or alternatives included in the spirit and scope of the disclosure.

Although the terms first, second, etc. may be used herein to describe various elements or components, these elements or components should not be limited by these terms. These terms are only used to distinguish one element or component from another element or component.

When an element is referred to as being "connected to" or "coupled to" another element, it may be directly connected or coupled to the other element or intervening elements may be present. In contrast, when an element is referred to as being "directly connected to" or "directly coupled to" another element, there are no intervening elements present.

The singular forms are intended to include the plural forms as well, unless the context clearly indicates otherwise.

Hereinafter, the present disclosure will now be described more fully with reference to the accompanying drawings, in which exemplary embodiments of the present disclosure are shown such that one of ordinary skill in the art may easily work the present disclosure. However, the present disclosure may be implemented in various different forms and is not limited to the embodiments described herein.

The same or similar components will be assigned the same reference numerals regardless of the reference numerals in the drawings, and the same descriptions thereof will be omitted.

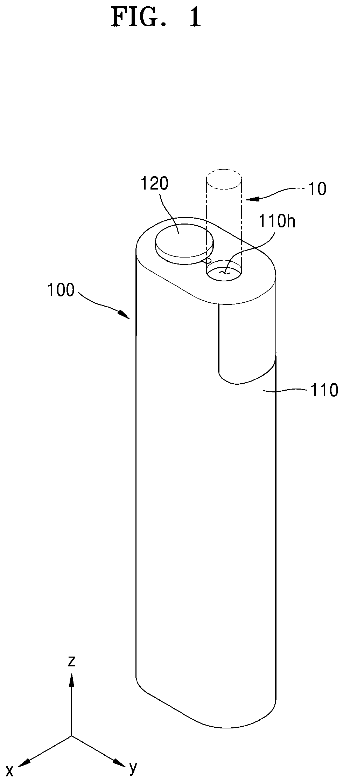

FIG. 1 is a perspective view illustrating an aerosol-generating device according to an embodiment.

Referring to FIG. 1, an aerosol-generating device 100 according to an embodiment may include a housing 110 capable of accommodating at least a portion of an aerosol-generating article 10 (or 'cigarette').

The housing 110 may form the overall appearance of the aerosol-generating device 100, and components of the aerosol-generating device 100 may be arranged in an internal space (or 'mounting space') of the housing 110. For example, a heater, a battery, and/or a processor for heating the aerosol-generating article 10 may be arranged in the internal space of the housing 110, but the components of the aerosol-generating device 100 arranged in the internal space of the housing 110 are not limited thereto.

According to an embodiment, the housing 110 may include an accommodation space 110h (or 'cavity') for accommodating at least a portion of the aerosol-generating article 10. The aerosol-generating article 10 may be inserted or accommodated into the interior of the housing 110 through the accommodation space 110h, and the aerosol-generating article 10 accommodated in the housing 110 may be heated by a heater arranged in the internal space of the housing 110.

As the aerosol-generating article 10 is heated by a heater assembly, an aerosol may be generated inside the housing 110, and the generated aerosol may be discharged to the outside of the aerosol-generating device 100 through the aerosol-generating article 10 or an empty space between the aerosol-generating article 10 and the accommodation space 110h and supplied to the user.

In the drawings, only an embodiment in which the overall appearance of the aerosol-generating device 100 is formed to have a columnar shape with an elliptical cross-section is illustrated, but the shape of the aerosol-generating device 100 is not limited to the illustrated embodiment. In another embodiment (not illustrated), the aerosol-generating device 100 may be formed to have a cylindrical shape overall, or may be formed to have a polygonal column (e.g., a triangular column or a square column) shape.

According to an embodiment, the aerosol-generating device 100 may further include a cover 120 that is movably arranged in the housing 110 to open or close the accommodation space 110h.

In an example, the cover 120 may be arranged to cover the accommodation space 110h in a first position (or 'closed position') so that the accommodation space 110h is not exposed to the outside of the aerosol-generating device 100. The cover 120 is positioned at the first position and prevents the accommodation space 110h from being exposed to the outside, thereby protecting the accommodation space 110h from external impact or foreign materials.

In another example, the cover 120 may be moved from the first position to a second position (or 'open position') so that the accommodation space 110h is exposed to the outside, and when the cover 120 is at the second position, the aerosol-generating article 10 may be accommodated or inserted into the inside of the accommodation space 110h.

According to an embodiment, the cover 120 may sliding-move between the first position and the second position along a groove formed in one area (e.g., an area facing the z direction) of the housing, but the method of moving the cover (120) is not limited thereto. In addition, the cover 120 that has moved from the first position to the second position may return to the first position by elastic force (or 'restoring force') even without a separate operation by the user, but is not limited thereto.

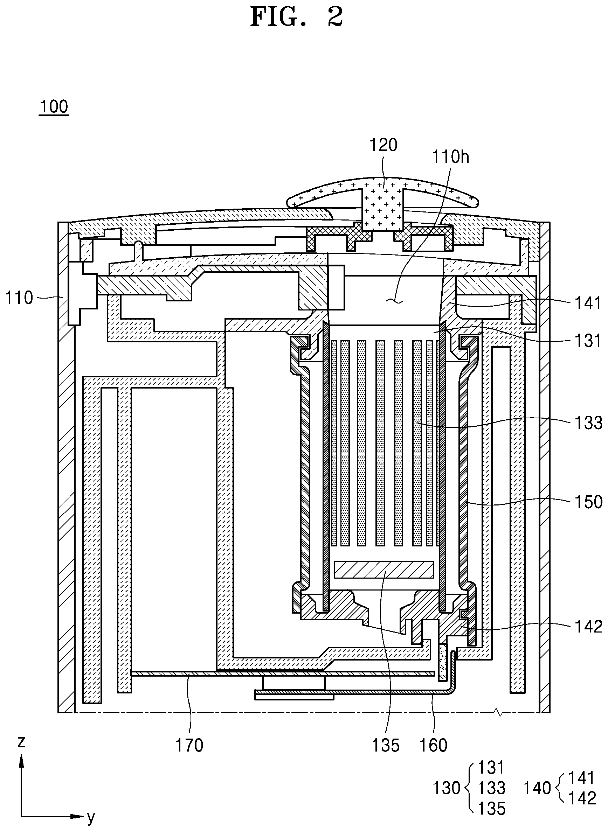

Hereinafter, components of the aerosol-generating device 100 arranged in the internal space of the housing 110 will be specifically described with reference to FIG. 2.

FIG. 2 is a view showing a partial cross-section of the aerosol-generating device illustrated in FIG. 1.

Referring to FIG. 2, the aerosol-generating device 100 according to an embodiment may include a housing 110, a cover 120, and a heater 130. The components of the aerosol-generating device 100 are not limited thereto, and at least one component may be added to the aerosol-generating device 100 according to an embodiment, or one (e.g., the cover 120) of the components described above may be omitted.

The housing 110 forms the overall appearance of the aerosol-generating device 100, and a space, in which components of the aerosol-generating device 100 may be arranged, may be provided inside the housing 110.

According to an embodiment, the housing 110 may include an accommodation space 110h, and at least a portion of an aerosol-generating article (e.g., the aerosol-generating article 10 of FIG. 1) may be inserted or accommodated into the housing 110 through the accommodation space 110h. Although FIG. 2 illustrates an embodiment in which the accommodation space 110h is formed in an area of the housing 110 in the z direction, the arrangement structure of the accommodation space 110h is not limited to the illustrated embodiment. In another embodiment (not illustrated), the accommodation space 110h may be formed in an area of the housing 110 in the y direction or the -y direction.

The heater 130 is positioned in the internal space of the housing 110 and may heat the aerosol-generating article 10 accommodated in the accommodation space 110h to generate an aerosol as power is supplied from a battery (not shown). For example, the heater 130 is arranged to surround the outer surface of the aerosol-generating article 10 accommodated in the accommodation space 110h and may heat the aerosol-generating article by generating heat as power is supplied. In this case, the vaporized particles generated as the aerosol-generating article is heated and the air flowing in from the outside through the accommodation space 110h may be mixed to generate an aerosol.

According to an embodiment, the heater 130 may include a polyimide film 131, a conductive pattern 133, and a sensing pad 135.

The polyimide film 131 (or 'base film') may include a polyimide (PI) having heat resistance or insulation to form the base of the heater 130, and may be arranged to surround the outer surface of the aerosol-generating article accommodated in the accommodation space 110h inside the housing 110.

The conductive pattern 133 may be arranged on the polyimide film 131 and may heat the aerosol-generating article as power is supplied. For example, the conductive pattern 133 may be arranged on an area (e.g., an inner area) of the polyimide film 131 facing the aerosol-generating article and may be electrically connected to a battery (not shown). The conductive pattern 133 may generate heat as power is supplied from the battery and may heat the aerosol-generating article.

According to an embodiment, the conductive pattern 133 may include stainless steel applied or printed on the polyimide film 131, but the manner in which the conductive pattern 133 is arranged on the polyimide film 131 or the type of the conductive pattern 133 is not limited thereto.

The sensing pad 135 may be arranged on the polyimide film 131 so as not to overlap the conductive pattern 133 and may perform a function of detecting capacitance within the accommodation space 110h. For example, the sensing pad 135 may include at least one electrode pattern arranged so as not to overlap the conductive pattern 133. In the present disclosure, the expression 'the sensing pad 135 is arranged so as not to overlap the conductive pattern 133' may mean a structure in which the sensing pad 135 and the conductive pattern 133 are arranged so as not to overlap each other when viewed in the radial direction of the heater 130.

When the sensing pad 135 is arranged to overlap the conductive pattern 133, the detection performance for the capacitance of the sensing pad 135 may be degraded or the sensing pad 135 may be damaged due to the heat generated from the conductive pattern 133 as power is supplied to the conductive pattern 133. On the other hand, the aerosol-generating device 100 according to an embodiment may prevent malfunction of or damage to the sensing pad 135 due to the heat generated from the conductive pattern 133 by arranging the conductive pattern 133 and the sensing pad 135 on the polyimide film 131 so that the conductive pattern 133 and the sensing pad 135 do not overlap each other.

The sensing pad 135 may be electrically or operatively connected to a processor (not shown), arranged on a printed circuit board 170, through an electrical connection member 160, and the processor may detect a capacitance value inside the accommodation space 110h through the sensing pad 135.

The processor may detect whether an aerosol-generating article is accommodated in the accommodation space 110h or whether the aerosol-generating article accommodated in the accommodation space 110h is overly moist, based on a change in the capacitance value inside the accommodation space 110h detected through the sensing pad 135, but a detailed description thereof will be provided below.

According to an embodiment, the aerosol-generating device 100 may further include a fixing member 140 and an insulating member 150.

The fixing member 140 may fix the position of the heater 130 inside the housing 110. According to an embodiment, the fixing member 140 may include an upper fixing member 141 (or 'first fixing member') and a lower fixing member 142 (or 'second fixing member').

The upper fixing member 141 may be positioned at the upper end (e.g., in the z direction of FIG. 2) of the heater 130 within the housing 110 and may fix the position of one end (or 'upper end') of the heater 130 in the z direction.

The lower fixing member 142 may be positioned at the lower end (e.g., in the -z direction of FIG. 2) of the heater 130 within the housing 110 and spaced apart from the upper fixing member 141 and may fix the position of the other end (or 'lower end') of the heater 130 in the - z direction.

The insulating member 150 may be arranged to surround the outer surface of the heater 130 inside the housing 110 and may block heat generated from the heater 130 from being transferred to the outer surface of the housing 110. For example, when heat generated from the heater 130 is transferred to the outer surface of the housing 110, the temperature of the surface of the housing 110 may excessively rise, making it difficult for a user to hold the housing 110.

The aerosol-generating device 100 according to an embodiment may improve user convenience by preventing the temperature of the surface of the housing 110 from excessively rising due to heat generated from the heater 130 through the insulating member 150.

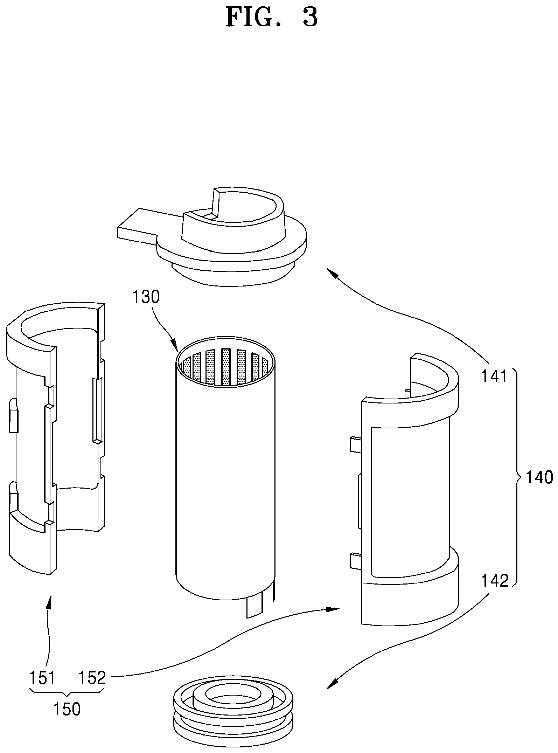

Hereinafter, with reference to FIG. 3, the coupling relationship between the heater 130, the fixing member 140, and the insulating member 150 will be specifically described.

FIG. 3 is an exploded perspective view showing a heater, a fixing member, and an insulating member of an aerosol-generating device according to an embodiment. A heater 130, a fixing member 140, and an insulating member 150 illustrated in FIG. 3 may be embodiments of the heater 130, the fixing member 140, and the insulating member 150 of the aerosol-generating device 100 of FIG. 2, respectively and redundant descriptions thereof are omitted below.

Referring to FIG. 3, the fixing member 140 may fix the position of the heater 130 inside the aerosol-generating device. For example, the fixing member 140 may be coupled to at least one area of the heater 130 to fix the position of the heater 130 so that the heater 130 does not move inside a housing (e.g., the housing 110 of FIGS. 1 to 2) during the use of the aerosol-generating device.

According to an embodiment, the fixing member 140 may include an upper fixing member 141 coupled to one end of the heater 130 and a lower fixing member 142 coupled to the other end opposite to one end of the heater 130.

The upper fixing member 141 may be coupled to one end of the heater 130 in an upper direction (e.g., the z direction of FIG. 2) and may fix the position of one end of the heater 130 inside the housing.

The lower fixing member 142 may be spaced apart from the upper fixing member 141 and may be connected to the other end of the heater 130 in a lower direction (e.g., the -z direction of FIG. 2), and may fix the position of the other end of the heater 130 inside the housing.

According to an embodiment, an aerosol-generating device (e.g., the aerosol-generating device 100 of FIGS. 1 to 2) may stably heat an aerosol-generating article (e.g., the aerosol-generating article 10 of FIG. 1) by fixing the position of the heater 130 inside the housing through the upper fixing member 141 and/or the lower fixing member 142.

For example, the fixing member 140 may be formed of a polymer material (e.g., polyether ether ketone (PEEK)) having excellent chemical resistance and stiffness as the fixing member 140 is placed adjacent to the heater 130 where an aerosol is generated, but the material of the fixing member 140 is not limited thereto.

The insulating member 150 may be arranged to surround the outer surface of the heater 130 and may block the heat generated from the heater 130 from being released to the outside. For example, the insulating member 150 may be arranged to surround the outer surface of the heater 130 and may block the heat generated from the heater 130 during the heating process of the aerosol-generating article from reaching the outer surface of the housing.

According to an embodiment, the insulating member 150 may include a first insulating member 151 and a second insulating member 152 coupled to the first insulating member 151. For example, the first insulating member 151 and the second insulating member 152 may be coupled to each other in a manner in which a protrusion of the second insulating member 152 is coupled to a recess of the first insulating member 151, but the method of coupling between the first insulating member 151 and the second insulating member 152 is not limited thereto.

When the first insulating member 151 and the second insulating member 152 are coupled to each other, the first insulating member 151 may be arranged to surround at least one side of the heater 130, and the second insulating member 152 may be arranged to surround the remaining side of the heater 130.

In an aerosol-generating device according to an embodiment, when the first insulating member 151 and the second insulating member 152 are coupled to each other, the first insulating member 151 and the second insulating member 152 may be arranged to completely surround the circumference of the heater 130, thereby effectively blocking the heat generated from the heater 130 from being released to the outside.

For example, the insulating member 150 may be formed of a polymer material (e.g., PEEK) having excellent heat resistance, but the material of the insulating member 150 is not limited thereto.

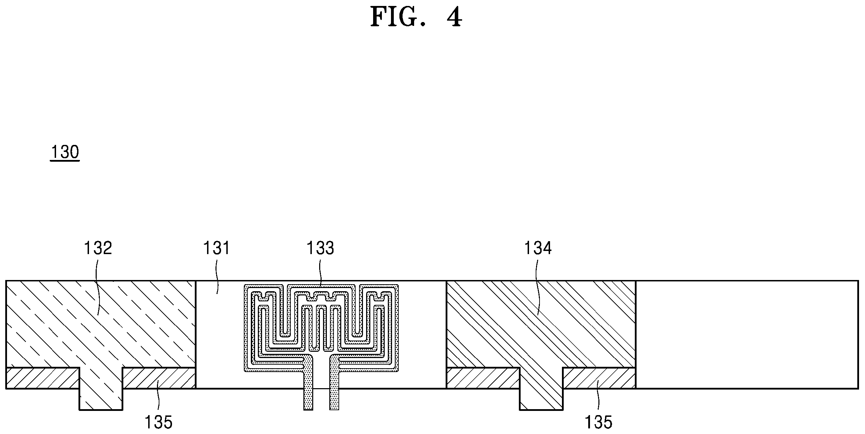

Hereinafter, the process of manufacturing the heater 130 will be specifically described with reference to FIGS. 4 to 6.

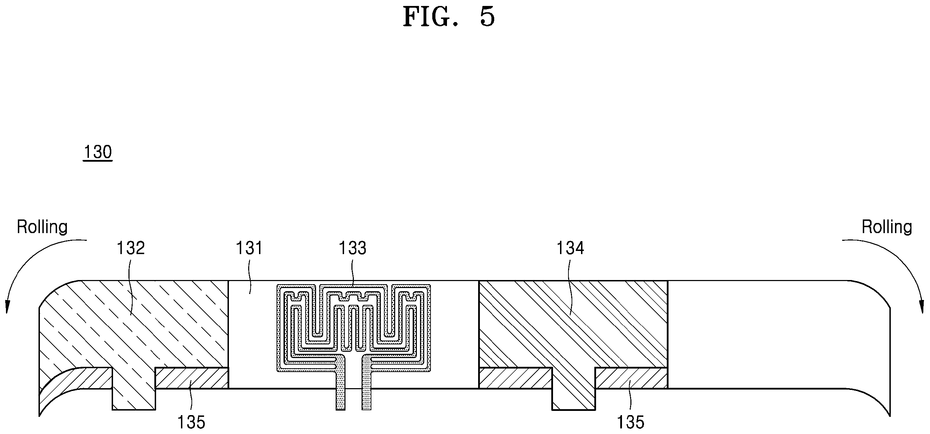

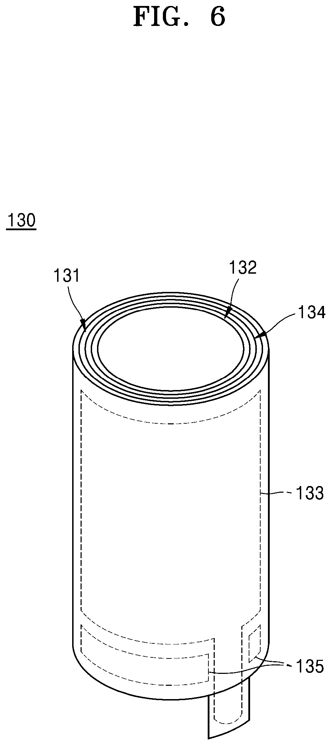

FIG. 4 is a view showing the arrangement structure of components of a heater in a state where a polyimide film is unfolded, according to an embodiment, FIG. 5 is a view for explaining a process of rolling the polyimide film shown in FIG. 4, and FIG. 6 is a perspective view showing components of a heater when the polyimide film shown in FIG. 5 is completely rolled.

Referring to FIGS. 4 to 6, a heater 130 according to an embodiment may include a polyimide film 131, an inner sheet 132, a conductive pattern 133, an outer sheet 134, and a sensing pad 135. The heater 130 shown in FIGS. 4 to 6 may be an embodiment of a heater 130 applicable to the aerosol-generating device 100 of FIGS. 1 to 2, and redundant descriptions thereof are omitted below.

The inner sheet 132 may be arranged in one area of the polyimide film 131 when the polyimide film 131 is unfolded, as shown in FIG. 4. For example, the inner sheet 132 may include a material (e.g., stainless steel) having high thermal conductivity and elasticity and may be arranged at one end of the polyimide film 131 when the polyimide film 131 is unfolded.

The outer sheet 134 may be arranged in another area of the polyimide film 131 that is spaced apart from the inner sheet 132 when the polyimide film 131 is unfolded. For example, the outer sheet 134 may include a material (e.g., stainless steel) having high thermal conductivity and elasticity, like the inner sheet 132, and may be arranged in another area of the polyimide film 131 that is spaced apart from the inner sheet 132 by the length of the inner sheet 132.

As the inner sheet 132 and the outer sheet 134 are spaced apart from each other on the polyimide film 131, an area where no sheet is arranged may be formed between the inner sheet 132 and the outer sheet 134 of the polyimide film 131, and a conductive pattern 133 may be printed or applied to the area. That is, when the polyimide film 131 is in an unfolded state, the inner sheet 132, the conductive pattern 133, and the outer sheet 134 may be arranged in order on the polyimide film 131.

At least a portion (hereinafter, referred to as a 'terminal area') of the conductive pattern 133 may be arranged to be exposed to the outside of the polyimide film 131, and a terminal area of the conductive pattern 133 may be electrically connected to a battery (not shown) and receive power from the battery.

The sensing pad 135 may be arranged on the inner sheet 132 and/or the outer sheet 134 and may detect a change in the capacitance value. The sensing pad 135 may include at least one electrode pattern printed or mounted on the inner sheet 132 and/or the outer sheet 134, and an aerosol-generating device (e.g., the aerosol-generating device 100 of FIGS. 1 and 2) may detect a change in the capacitance value based on the size and/or frequency of an electrical signal received from the at least one electrode pattern.

According to an embodiment, the sensing pad 135 may be arranged on a lower area of the inner sheet 132 and/or the outer sheet 134, as illustrated in FIG. 4, but the arrangement structure of the sensing pad 135 is not limited thereto. In another embodiment, the sensing pad 135 may be arranged on an upper area of or the center of the inner sheet 132 and/or the outer sheet 134 as long as the sensing pad 135 is arranged so as not to overlap the conductive pattern 133.

In addition, although the drawings only shows an embodiment in which the sensing pad 135 is arranged on both the inner sheet 132 and the outer sheet 134, the sensing pad 135 may be arranged on only one of the inner sheet 132 and the outer sheet 134 depending on an embodiment.

The heater 130 may be formed as the polyimide film 131 in an unfolded state is rolled into a circular or oval shape. For example, as shown in FIG. 5, one end of the polyimide film 131 on which the inner sheet 132 is positioned and the other end of the polyimide film 131 may be rolled. When the polyimide film 131 is completely rolled as shown in FIG. 6, a tube-shaped heater 130 having a circular or oval cross-section may be formed. The tube-shaped heater 130 may be arranged to surround the outer surface of an aerosol-generating article (e.g., the aerosol-generating article 10 of FIG. 1) inside an aerosol-generating device, and may generate heat to heat the aerosol-generating article as power is supplied to the conductive pattern 133.

When the polyimide film 131 is completely rolled (or the heater 130 is completely manufactured), the inner sheet 132 may be arranged on the inner surface of the heater 130, and the outer sheet 134 may be spaced apart in a radial direction from the inner sheet 132.

The conductive pattern 133 and the sensing pad 135 arranged on the inner sheet 132 and/or the outer sheet 134 may be arranged between the inner sheet 132 and the outer sheet 134, and as the outer surface of the outer sheet 134 is wrapped by the polyimide film 131, the positions of the inner sheet 132, the conductive pattern 133, the sensing pad 135, and the outer sheet 134 may be stably fixed.

The sensing pad 135 may be arranged between the inner sheet 132 and the outer sheet 134 so as not to overlap the conductive pattern 133. When the sensing pad 135 overlaps the conductive pattern 133, the sensing pad 135 may malfunction or be damaged by heat generated from the conductive pattern 133. On the other hand, the heater 130 according to an embodiment may prevent the sensing pad 135 from being damaged or malfunctioning by heat generated from the conductive pattern 133, through a structure in which the sensing pad 135 is arranged so as not to overlap the conductive pattern 133.

According to an embodiment, the heater 130 may be manufactured by arranging the inner sheet 132, the conductive pattern 133, the outer sheet 134, and the sensing pad 135 on the polyimide film 131 and rolling the polyimide film 131, and thus, the process of combining the inner sheet 132, the conductive pattern 133, the outer sheet 134, etc. may be omitted, thereby simplifying the process of manufacturing the heater 130.

In addition, according to an embodiment, the heater 130 may utilize the sensing pad 135 without having a separate configuration (e.g., an additional layer) in which the sensing pad 135 may be arranged through a structure in which the sensing pad 135 is arranged on the inner sheet 132 and/or the outer sheet 134 for fixing the conductive pattern 133. As a result, the manufacturing cost of the aerosol-generating device may be reduced, and a space (or 'mounting space') occupied by the sensing pad 135 inside the aerosol-generating device may be minimized, thereby facilitating miniaturization of the aerosol-generating device.

In addition, in the aerosol-generating device according to an embodiment, the sensing pad 135 may be arranged adjacent to an accommodation space (e.g., the accommodation space 110h of FIGS. 1 to 2) whose capacitance is to be detected through the arrangement structure of the sensing pad 135 described above, and thus, a change in capacitance of the accommodation space may be detected more precisely. As a result, the aerosol-generating device may more accurately determine whether an aerosol-generating article is accommodated in the accommodation space or whether the accommodated aerosol-generating article is in an over-moisture state, thereby improving user convenience.

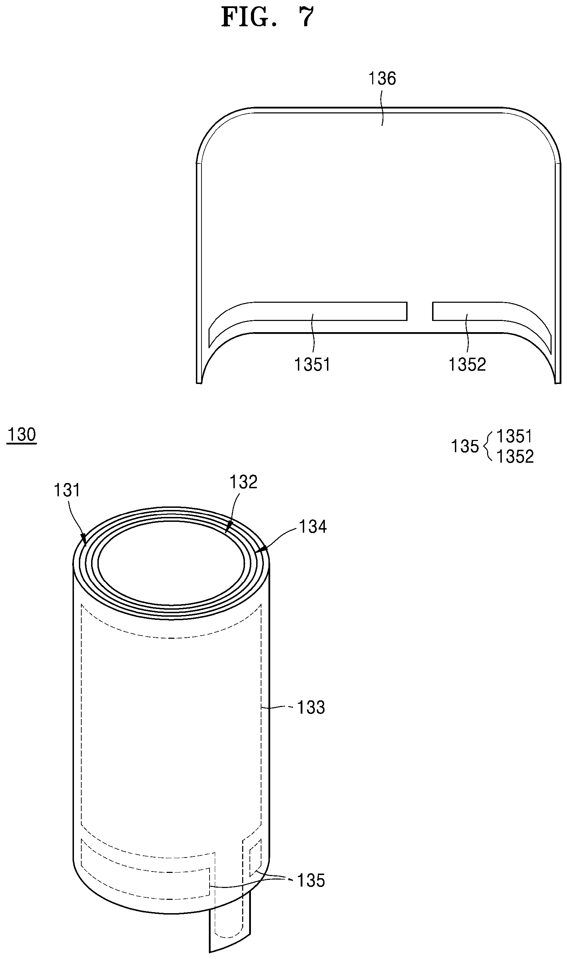

FIG. 7 is a perspective view showing a protective sheet for surrounding the outer surface of a polyimide film according to another embodiment.

Referring to FIG. 7, according to another embodiment, a heater 130 may include a polyimide film 131, an inner sheet 132, a conductive pattern 133, an outer sheet 134, a sensing pad 135, and a protective sheet 136. The heater 130 illustrated in FIG. 7 may be a component of the heater 130 of FIG. 6 to which a protective sheet 136 is added, and redundant descriptions thereof are omitted below.

The protective sheet 136 may be arranged at the outermost portion of the heater 130 and may fix the polyimide film 131, the inner sheet 132, the conductive pattern 133, and the outer sheet 134 of the heater 130. For example, the inner sheet 132, the conductive pattern 133, the outer sheet 134, the polyimide film 131, and the protective sheet 136 may be arranged in this order based on the radial direction of the heater 130, and the protective sheet 136 may be arranged at the outermost edge of the heater 130 to prevent the inside of the heater 130 from being subjected to external impact or the introduction of foreign materials.

The sensing pad 135 may be arranged on the inner side of the protective sheet 136, which faces the polyimide film 131, so as not to overlap the conductive pattern 133, and the aerosol-generating device (e.g., the aerosol-generating device 100 of FIGS. 1 to 2) may detect the capacitance of the accommodation space (e.g., the accommodation space 110h of FIGS. 1 to 2), in which the aerosol generating article is accommodated, through the sensing pad 135.

For example, a processor of the aerosol-generating device may calculate the difference between a capacitance value of the accommodation space detected through a sensing pad 135 (or 'internal sensing pad') arranged between the inner sheet 132 and the outer sheet 134 and a capacitance value of the accommodation space detected through a sensing pad 135 (or 'external sensing pad') arranged on the protective sheet 136. The processor may control the operation of the aerosol-generating device based on the calculated difference between the capacitance values. A specific description of the process of controlling the operation of the aerosol-generating device by the processor will be described below.

Only an embodiment in which the sensing pad 135 is arranged both in an area between the inner sheet 132 and the outer sheet 134 and on the inner side of the protective sheet 136 facing the polyimide film 131 is illustrated in the drawings, but is not limited thereto.

In another embodiment, the sensing pad 135 may be arranged only on the inner side of the protective sheet 136 facing the polyimide film 131. In this case, the processor may detect a change in the capacitance value of the accommodation space detected through the sensing pad 135 arranged on the inner side of the protective sheet 136 facing the polyimide film 131 (self-capacitance sensing), and may control the operation of the aerosol-generating device based on the detected change in the capacitance value.

According to an embodiment, the sensing pad 135 may include a plurality of sensing pads 1351 and 1352. For example, the sensing pad 135 may include a first sensing pad 1351 and a second sensing pad 1352 spaced apart from the first sensing pad 1351. In this case, the processor may calculate the difference between a capacitance value of the accommodation space detected through the first sensing pad 1351 and a capacitance value of the accommodation space detected through the second sensing pad 1352 (mutual-capacitance sensing), and may control the operation of the aerosol-generating device based on the calculated difference between the capacitance values.

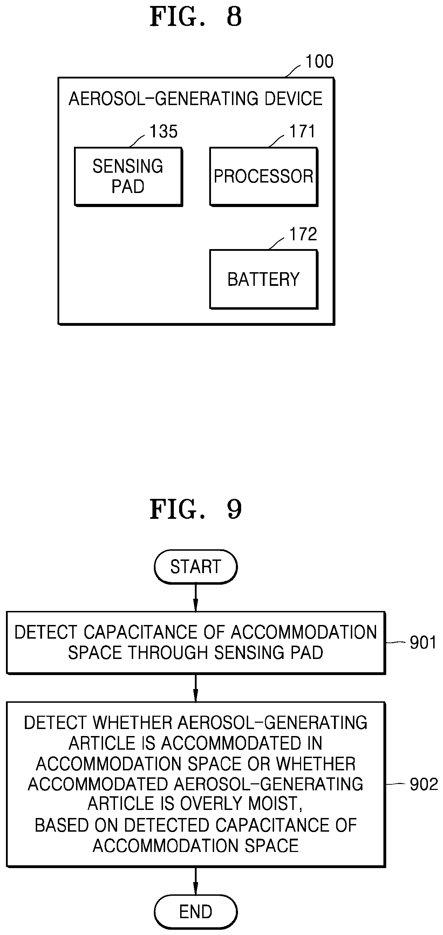

Hereinafter, with reference to FIGS. 8 and 9, a process of controlling the operation of the aerosol-generating device based on a capacitance value detected through the sensing pad 135 of the processor will be specifically described.

FIG. 8 is a block diagram showing some components of an aerosol-generating device according to an embodiment. At least one of components of an aerosol-generating device 100 illustrated in FIG. 8 may be substantially the same as or similar to at least one of the components of the aerosol-generating device 100 illustrated in FIGS. 1 and 2, and redundant descriptions thereof are omitted below.

Referring to FIG. 8, the aerosol-generating device 100 according to an embodiment may include a sensing pad 135 (e.g., the sensing pad 135 of FIGS. 2, 6, and 7), a processor 171, and a battery 172. FIG. 8 illustrates only some components of the aerosol-generating device 100 of FIGS. 1 and 2, and the components of the aerosol-generating device 100 are not limited to the illustrated components.

The sensing pad 135 may perform a function of detecting a capacitance inside an accommodation space (e.g., the accommodation space 110h of FIGS. 1 and 2). The sensing pad 135 may output an electrical signal corresponding to a change in the capacitance of the accommodation space, and the output electrical signal may be transmitted to a processor 171 electrically connected to the sensing pad 135.

The processor 171 may control all operations of the aerosol-generating device 100. For example, the processor 171 may be arranged on a printed circuit board (e.g., the printed circuit board 160 of FIG. 2) inside the aerosol-generating device 100 and may be electrically or operatively connected to the sensing pad 135 and the battery 172 to control all operations of the aerosol-generating device 100.

According to an embodiment, the processor 171 may detect a capacitance value inside the accommodation space through the sensing pad 135 and control an operation of the aerosol-generating device 100 based on the detected capacitance value. For example, the magnitude of the resistance of the sensing pad 135 may vary depending on the capacitance value inside the accommodation space, and as a result, the magnitude of the electrical signal generated from the sensing pad 135 may also vary. The processor may detect a change in the capacitance value inside the accommodation space based on the magnitude of the electrical signal transmitted from the sensing pad 135 and/or the frequency of power supplied to the sensing pad 135. In this case, the aerosol-generating device 100 may be placed on an electrical path between the sensing pad 135 and the battery 172, and may further include a filter (not shown) for detecting the frequency of the power supplied from the battery 172 to the sensing pad 135, but is not limited thereto.

In an example, the processor 171 may detect a change in the capacitance value inside the accommodation space through the sensing pad 135 and determine whether an aerosol-generating article (e.g., the aerosol-generating article 10 of FIG. 1) is accommodated in the accommodation space based on the detected change in the capacitance value. In another example, the processor 171 may determine whether the aerosol-generating article accommodated in the accommodation space is overly moist, based on the amount of change in the capacitance value detected through the sensing pad 135.

The battery 172 may supply power to operate the components of the aerosol-generating device 100. For example, the battery 172 may supply power to components, such as a heater (e.g., the heater 130 of FIG. 2) or the processor 171. In this case, the battery 172 may be a rechargeable battery or a disposable battery. For example, the battery 172 may be a lithium polymer (LiPoly) battery, but the type of the battery 172 is not limited thereto.

Hereinafter, with reference to FIG. 9, a process in which the processor 171 controls the operation of the aerosol-generating device 100 based on the capacitance value of the accommodation space detected through the sensing pad 135 will be specifically described.

FIG. 9 is a flowchart for explaining a control operation based on a capacitance value of an accommodation space detected through a sensing pad of an aerosol-generating device according to an embodiment. In explaining the control operation below, reference will be made to the components of the aerosol-generating device 100 illustrated in FIG. 8.

Referring to FIG. 9, in operation 901, the processor 171 of the aerosol-generating device 100 according to an embodiment may detect the capacitance of an accommodation space (e.g., the accommodation space 110h of FIGS. 1 to 2) through the sensing pad 135. For example, the processor 171 may detect the amount of change in the capacitance of the accommodation space, in which an aerosol-generating article (e.g., the aerosol-generating article 10 of FIG. 1) is accommodated, through the sensing pad 135.

In operation 902, the processor 171 of the aerosol-generating device 100 according to an embodiment may detect whether an aerosol-generating article is accommodated in the accommodation space or whether the accommodated aerosol-generating article is overly moist, based on the capacitance of the accommodation space detected in operation 901.

In an example, the processor 171 may detect whether an aerosol-generating article is accommodated inside the accommodation space, based on the amount of change in the capacitance of the accommodation space detected through the sensing pad 135. For example, when the processor 171 determines that an aerosol-generating article is accommodated inside the accommodation space, the processor 171 may supply power to a heater (e.g., the heater 130 of FIG. 2) through the battery 172 to preheat the heater.

In another example, when it is confirmed that the aerosol-generating article is accommodated in the accommodation space, the processor 171 may estimate the moisture content of the aerosol-generating article accommodated in the accommodation space, based on the change in the capacitance of the accommodation space detected through the sensing pad 135, and may detect whether the aerosol-generating article is in an over-moisture state, based on the estimated moisture content.

In the present disclosure, the expression 'the aerosol-generating article is in an over-moisture state' may mean a state in which a medium portion included in the aerosol-generating article includes moisture of a specified amount (e.g., 15 wt%) or more relative to the total weight of the medium portion, and the expression may be used with the same meaning hereinafter.

When an aerosol-generating article in an over-moisture state is heated, a high-temperature aerosol may be generated due to the high moisture content, and a user may feel discomfort when inhaling the high-temperature aerosol.

According to an embodiment, the processor 171 of the aerosol-generating device 100 may control the power supplied from the battery 172 to the heater when the aerosol-generating article accommodated in the accommodation space is in an over-moisture state, thereby increasing the preheating time of the aerosol-generating article compared to when heating a general aerosol-generating article. Accordingly, the aerosol-generating device 100 may prevent high-temperature aerosol from being generated, thereby improving the user's feeling of smoking.

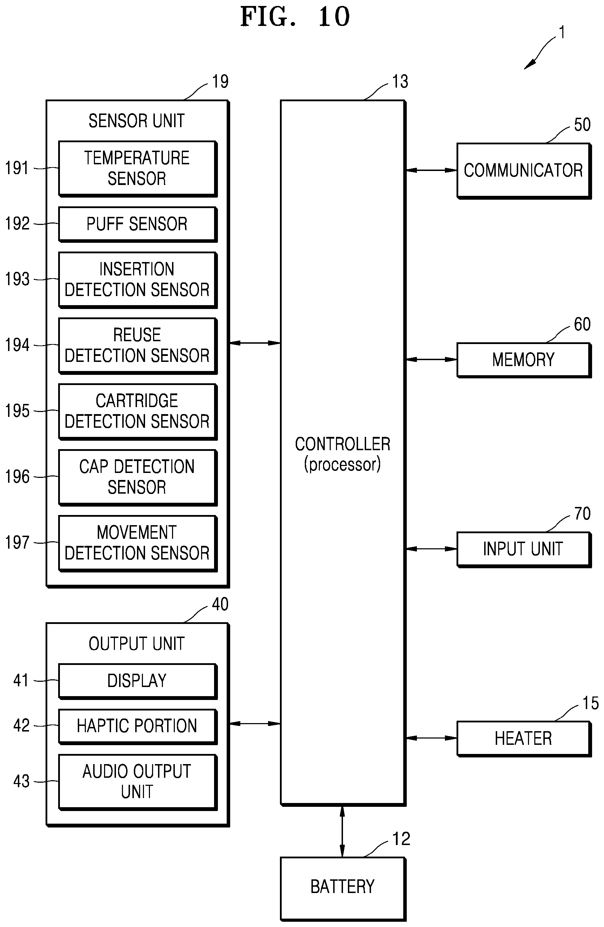

FIG. 10 is a block diagram of an aerosol-generating device according to an embodiment.

The aerosol generating device 1 may include a battery 12, a controller 13, a sensor unit 19, an output unit 40, an input unit 70, a communicator 50, a memory 60, and at least one heater 15. However, an internal structure of the aerosol generating device 1 is not limited to that illustrated in FIG. 10. In other words, according to the design of the aerosol generating device 1, one of ordinary skill in the art related to the present embodiment that some of the components shown in FIG. 10 may be omitted or new components may be added.

The sensor unit 19 may detect a state of the aerosol generating device 1 or a state around the aerosol generating device 1 and transmit detected information to the controller 13. On the basis of the detected information, the controller 13 may control the aerosol generating device 1 to perform various functions such as control of operations of the cartridge heater 15 and/or the heater 15, a restriction on smoking, determination of whether or not the stick and/or the cartridge 19 are inserted, and a notification display.

The sensor unit 19 may include at least one of a temperature sensor 191, a puff sensor 192, an insertion detection sensor 193, a reuse detection sensor 194, a cartridge detection sensor 195, a cap detection sensor 196, and a motion detection sensor 197.

The temperature sensor 191 may detect a temperature at which the cartridge heater 15 and/or the heater 15 are heated. The aerosol generating device 1 may include a separate temperature sensor for detecting the temperatures of the cartridge heater 15 and/or the heater 15, or the cartridge heater 15 and/or the heater 15 may operate as temperature sensors.

The temperature sensor 191 may output a signal corresponding to the temperature of the cartridge heater 15 and/or the heater 15. For example, the temperature sensor 191 may include a resistor element whose resistance value changes in correspondence to a change in the temperature of the cartridge heater 15 and/or the heater 15. The temperature sensor 191 may be implemented by a thermistor or the like, which is an element using a property of changing resistance according to temperature. Here, the temperature sensor 191 may output a signal corresponding to the resistance value of the resistor element as a signal corresponding to the temperature of the cartridge heater 15 and/or the heater 15. For example, the temperature sensor 191 may include a sensor that detects a resistance value of the cartridge heater 15 and/or the heater 15. Here, the temperature sensor 191 may output a signal corresponding to the resistance value of the cartridge heater 15 and/or the heater 15 as a signal corresponding to the temperature of the cartridge heater 15 and/or the heater 15.

The temperature sensor 191 may be arranged around the battery 12 to monitor a temperature of the battery 12. The temperature sensor 191 may be arranged adjacent to the battery 12. For example, the temperature sensor 191 may be attached to one surface of a battery that is the battery 12. For example, the temperature sensor 191 may be mounted on one surface of a PCB.

The temperature sensor 191 may be arranged inside the body to detect an internal temperature of the body.

The puff sensor 192 may detect a puff by a user on the basis of various physical changes in an air flow path. The puff sensor 192 may output a signal corresponding to the puff. For example, the puff sensor 192 may be a pressure sensor. The puff sensor 192 may output a signal corresponding to internal pressure of the aerosol generating device 1. Here, the internal pressure of the aerosol generating device 1 may correspond to pressure of the air flow path through which a gas flows. The puff sensor 192 may be arranged in correspondence to the air flow path through which the gas flows in the aerosol generating device 1.

The insertion detection sensor 193 may detect insertion and/or removal of the stick. The insertion detection sensor 193 may detect a signal change due to the insertion and/or removal of the stick. The insertion detection sensor 193 may be installed around an insertion space. The insertion detection sensor 193 may detect the insertion and/or removal of the stick according to a change in a dielectric constant inside the insertion space. For example, the insertion detection sensor 193 may be an inductive sensor and/or a capacitance sensor.

The inductive sensor may include at least one coil. The coil of the inductive sensor may be arranged adjacent to the insertion space. For example, when a magnetic field changes around the coil through which a current flows, characteristics of the current flowing through the coil may change according to Faraday's law of electromagnetic induction. Here, the characteristics of the current flowing through the coil may include a frequency of an alternating current, a current value, a voltage value, an inductance value, an impedance value, and the like.

The inductive sensor may output a signal corresponding to the characteristics of the current flowing through the coil. For example, the inductive sensor may output a signal corresponding to an inductance value of the coil.

The capacitance sensor may include a conductor. The conductor of the capacitance sensor may be arranged adjacent to the insertion space. The capacitance sensor may output a signal corresponding to an ambient electromagnetic characteristic, e.g., a capacitance around the conductor. For example, when the stick including a metal wrapper is inserted into the insertion space, the electromagnetic characteristic around the conductor may be changed by the wrapper of the stick.

The reuse detection sensor 194 may detect whether or not the stick is reused. The reuse detection sensor 194 may be a color sensor. The color sensor may detect a color of the stick. The color sensor may detect a color of a portion of the wrapper wrapping the outside of the stick. The color sensor may detect a value for an optical characteristic corresponding to a color of an object, on the basis of light reflected from the object. For example, the optical characteristic may be a wavelength of light. The color sensor may be implemented as a single component with a proximity sensor or may be implemented as a separate component distinguished from the proximity sensor.

At least a portion of the wrapper constituting the stick may have a color changing by an aerosol. When the stick is inserted into the insertion space, the reuse detection sensor 194 may be arranged in correspondence to a location at which at least the portion of the wrapper whose color changes by the aerosol is arranged. For example, before the stick is used by the user, the color of at least the portion of the wrapper may be a first color. Here, when at least the portion of the wrapper is wetted by the aerosol while the aerosol generated by the aerosol generating device 1 passes through the stick, the color of at least the portion of the wrapper may be changed to a second color. The color of at least the portion of the wrapper may be maintained in the second color after changing from the first color to the second color.

The cartridge detection sensor 195 may detect mounting and/or removal of the cartridge 19. The cartridge detection sensor 195 may be implemented by an inductance-based sensor, a capacitive sensor, a resistance sensor, a hall sensor (a hall IC) using a hall effect, or the like.

The cap detection sensor 196 may detect mounting and/or removal of a cap. When the cap is detached from the body, a portion of the cartridge 19 and the body covered by the cap may be exposed to the outside. The cap detection sensor 196 may be implemented by a contact sensor, a hall sensor (a hall IC), an optical sensor, or the like.

The motion detection sensor 197 may detect a motion of the aerosol generating device 1. The motion detection sensor 197 may be implemented as at least one of an acceleration sensor and a gyro sensor.

In addition to the sensors 191 to 197 described above, the sensor unit 19 may further include at least one of a humidity sensor, an atmospheric pressure sensor, a magnetic sensor, a position sensor (e.g., a global positioning system (GPS)), and a proximity sensor. Functions of the respective sensors may be intuitively inferred from names thereof by one of ordinary skill in the art, and thus, detailed descriptions thereof may be omitted.

The output unit 40 may output information regarding the state of the aerosol generating device 1 and provide the information to the user. The output unit 40 may include at least one of a display 41, a haptic unit 42, and a sound output unit 43, but is not limited thereto. When the display 41 and a touch pad form a layer structure to form a touch screen, the display 41 may be used as an input device in addition to an output device.

The display 41 may visually provide the user with information regarding the aerosol generating device 1. For example, the information regarding the aerosol generating device 1 may refer to various types of information such as a charging/discharging state of the battery 12 of the aerosol-generating device 1, a preheating state of the heater 15, the insertion/removal state of the stick and/or the cartridge 19, the mounting/removal state of the cap, and the restriction on use of the aerosol generating device 1 (e.g., detection of an abnormal article), and the display 41 may output the information to the outside. For example, the display 41 may be in the form of a light emitting diode (LED) light emitting device. For example, the display 41 may be a liquid crystal display (LCD) panel, an organic light emitting display (OLED)panel, or the like.

The haptic unit 42 may tactilely provide the user with the information regarding the aerosol generating device 1 by converting an electrical signal into a mechanical stimulus or an electrical stimulus. For example, when initial power is supplied to the cartridge heater 15 and/or the heater 15 for a set time, the haptic unit 42 may generate vibration corresponding to completion of initial preheating. The haptic unit 42 may include a vibration motor, a piezoelectric element, or an electrical stimulation device.

The sound output unit 43 may audibly provide the user with the information regarding the aerosol generating device 1. For example, the sound output unit 43 may convert the electrical signal into a sound signal and output the sound signal to the outside.

The battery 12 may supply power used to operate the aerosol generating device 1. The battery 12 may supply power so that the cartridge heater 15 and/or the heater 15 may be heated. In addition, the battery 12 may supply power needed for operations of the sensor unit 19, the output unit 40, the input unit 70, the communicator 50, and the memory 60, which are other components provided within the aerosol generating device 1. The battery 12 may be a rechargeable battery or a disposable battery. For example, the battery 12 may be a lithium polymer (LiPoly) battery, but is not limited thereto.

Although not shown in FIG. 10, the aerosol generating device 1 may further include a power protection circuit. The power protection circuit may be electrically connected to the battery 12 and may include a switching element.

The power protection circuit may cut off an electrical path for the battery 12 according to a certain condition. For example, the power protection circuit may cut off the electrical path for the battery 12 when a voltage level of the battery 12 is a first voltage or more corresponding to overcharging. For example, the power protection circuit may cut off the electrical path for the battery 12 when the voltage level of the battery 12 is less than a second voltage corresponding to overdischarge.

The heater 15 may be supplied with power from the battery 12 and heat a medium or an aerosol generating material within the stick. Although not shown in FIG. 10, the aerosol generating device 1 may further include a power conversion circuit (e.g., a DC/DC converter) that converts power of the battery 12 and supplies the converted power to the cartridge heater 15 and/or the heater 15. In addition, when the aerosol generating device 1 generates an aerosol by an induction heating method, the aerosol generating device 1 may further include a DC/AC converter that converts DC power of the battery 12 into AC power.

The controller 13, the sensor unit 19, the output unit 40, the input unit 70, the communicator 50, and the memory 60 may be supplied with power from the battery 12 to perform functions. Although not shown in FIG. 10, the aerosol generating device 1 may further include a power conversion circuit that converts power of the battery 12 and supplies the power to each of components, e.g., a low-dropout (LDO) circuit or a voltage regulator circuit. Also, although not shown in FIG. 10, a noise filter may be provided between the battery 12 and the heater 15. The noise filter may be a low pass filter. The low pass filter may include at least one inductor and a capacitor. A cutoff frequency of the low pass filter may correspond to a frequency of a high-frequency switching current applied from the battery 12 to the heater 15. The low pass filter may prevent a high-frequency noise component from being applied to the sensor unit 19, such as the insertion detection sensor 193.

In an embodiment, the cartridge heater 15 and/or the heater 15 may be formed of any suitable electrically resistive material. For example, the suitable electrically resistive material may be a metal or a metal alloy including titanium, zirconium, tantalum, platinum, nickel, cobalt, chromium, hafnium, niobium, molybdenum, tungsten, tin, gallium, manganese, iron, copper, stainless steel, or nichrome, but is not limited thereto. In addition, the heater 15 may be implemented by a metal wire, a metal plate on which an electrically conductive track is arranged, or a ceramic heating element, but is not limited thereto.

In an embodiment, the heater 15 may include an induction heater. For example, the heater 15 may include a susceptor that generates heat through a magnetic field applied by a coil to heat an aerosol generating material.

The input unit 70 may receive information input from the user or output the information to the user. For example, the input unit 70 may be a touch panel. The touch panel may include at least one touch sensor for detecting a touch. For example, the touch sensor may include a capacitive touch sensor, a resistive touch sensor, a surface acoustic touch sensor, an infrared touch sensor, or the like, but is not limited thereto.

The display 41 and the touch panel may be implemented as one panel. For example, the touch panel may be inserted into the display 41 (e.g., may be a on-cell type or in-cell type). For example, the touch panel may be added on the display 41 (e.g., may be an add-on type).

Meanwhile, the input unit 70 may include a button, a keypad, a dome switch, a jog wheel, a jog switch, or the like, but is not limited thereto.

The memory 60 may be hardware for storing various types of data processed within the aerosol generating device 1 and may store pieces of data processed by the controller 13 and pieces of data to be processed by the controller 13. The memory 60 may include at least one type of storage medium from among a flash memory type, a hard disk type, a multimedia card micro type, a card type memory (e.g., a SD or XD memory or the like), random access memory (RAM), static random access memory (SRAM), read-only memory (ROM), electrically erasable programmable read-only memory (EEPROM), programmable read-only memory (PROM), a magnetic memory, a magnetic disk, and an optical disk. The memory 60 may store data or the like regarding an operation time of the aerosol generating device 1, the maximum number of puffs, the current number of puffs, at least one temperature profile, and a smoking pattern of the user.

The communicator 50 may include at least one component for communication with another electronic device. For example, the communicator 50 may include at least one of a short-range wireless communication unit and a wireless communication unit.

The short-range wireless communication unit may include a Bluetooth communication unit, a Bluetooth low energy (BLE) communication unit, a near field communication unit, a wireless local area network ((WLAN) (Wi-Fi)) communication unit, a Zigbee communication unit, an infrared data association (IrDA) communication unit, a Wi-Fi Direct (WFD) communication unit, an ultra wideband (UWB) communication unit, an Ant+ communication unit, and the like, but is not limited thereto.

The wireless communication unit may include a cellular network communication unit, an Internet communication unit, a computer network (e.g., LAN or WAN) communication unit, and the like, but is not limited thereto.

Although not shown in FIG. 10, the aerosol generating device 1 may further include a connection interface such as a universal serial bus (USB) interface, and may connect with another external device through the connection interface such as a USB interface to transmit and receive information or charge the power 11.

The controller 13 may control an overall operation of the aerosol generating device 1. In an embodiment, the controller 13 may include at least one processor. The processor may be implemented as an array of a plurality of logic gates or may be implemented as a combination of a general-purpose microprocessor and a memory that stores a program executable by the microprocessor. In addition, one of ordinary skill in the art to which the present embodiment pertains may understand that the processor may be implemented as other types of hardware.

The controller 13 may control the temperature of the heater 15 by controlling supply power from the battery 12 to the heater 15. The controller 13 may control the temperature of the cartridge heater 15 and/or the heater 15 on the basis of the temperature of the cartridge heater 15 and/or the heater 15 sensed by the temperature sensor 191. The controller 13 may adjust power supplied to the cartridge heater 15 and/or the heater 15, on the basis of the temperature of the cartridge heater 15 and/or the heater 15. For example, the controller 13 may determine a target temperature for the cartridge heater 15 and/or the heater 15, on the basis of a temperature profile stored in the memory 60.

The aerosol generating device 1 may include a power supply circuit (not shown) electrically connected to the battery 12 between the battery 12 and the cartridge heater 15 and/or the heater 15. The power supply circuit may be electrically connected to the cartridge heater 15, the heater 15, or an induction coil 181. The power supply circuit may include at least one switching element. The switching element may be implemented by a bipolar junction transistor (BJT), a field effective transistor (FET), or the like. The controller 13 may control the power supply circuit.

The controller 13 may control power supply by controlling switching of the switching element of the power supply circuit. The power supply circuit may be an inverter that converts DC power output from the battery 12 into AC power. For example, the inverter may include a full-bridge circuit or a half-bridge circuit including a plurality of switching elements.

The controller 13 may turn on the switching element so that power is supplied from the battery 12 to the cartridge heater 15 and/or the heater 15. The controller 13 may turn off the switching element to cut off the supply of power to the cartridge heater 15 and/or the heater 15. The controller 13 may adjust a current supplied from the battery 12 by adjusting a frequency and/or duty ratio of a current pulse input into the switching element.

The controller 13 may control a voltage output from the battery 12 by controlling switching of the switching element of the power supply circuit. The power conversion circuit may convert the voltage output from the battery 12. For example, the power conversion circuit may include a buck-converter that steps down the voltage output from the battery 12. For example, the power conversion circuit may be implemented through a buck-boost converter, a zener diode, or the like.

The controller 13 may adjust a level of the voltage output from the power conversion circuit by controlling an on/off operation of the switching element included in the power conversion circuit. When the switching element continues to be turned on, the level of the voltage output from the power conversion circuit may correspond to a level of a voltage output from the battery 12. The duty ratio for the on/off operation of the switching element may correspond to a ratio of the voltage output from the power conversion circuit to the voltage output from the battery 12. The level of the voltage output from the power conversion circuit may decrease with a decrease in the duty ratio for the on/off operation of the switching element. The heater 15 may be heated on the basis of the voltage output from the power conversion circuit.

The controller 13 may control power to be supplied to the heater 15 by using at least one of a pulse width modulation (PWM) method and a proportional-integral-differential (PID) method.

For example, the controller 13 may control a current pulse having a certain frequency and duty ratio to be supplied to the heater 15 by using the PWM method. The controller 13 may control the power supplied to the heater 15 by adjusting the frequency and duty ratio of the current pulse.

For example, the controller 13 may determine a target temperature to be controlled, on the basis of the temperature profile. The controller 13 may control the power supplied to the heater 15 by using the PID method, which is a feedback control method through a difference value between the temperature of the heater 15 and the target temperature, a value obtained by integrating the difference value over time, and a value obtained by differentiating the difference value over time.

The controller 13 may prevent the cartridge heater 15 and/or the heater 15 from overheating. For example, on the basis that the temperature of the cartridge heater 15 and/or the heater 15 exceeds a preset limit temperature, the controller 13 may control an operation of the power conversion circuit so that the supply of power to the cartridge heater 15 and/or the heater 15 stops. For example, on the basis that the temperature of the cartridge heater 15 and/or the heater 15 exceeds the preset limit temperature, the controller 13 may reduce an amount of power supplied to the cartridge heater 15 and/or the heater 15 by a certain ratio. For example, on the basis that the temperature of the cartridge heater 15 exceeds the preset limit temperature, the controller 13 may determine that the aerosol generating material accommodated in the cartridge 19 is exhausted and cut off the power supply to the cartridge heater 15.

The controller 13 may control charging and discharging of the battery 12. The controller 13 may identify the temperature of the battery 12 on the basis of an output signal of the temperature sensor 191.

When a power line is connected to a battery terminal of the aerosol generating device 1, the controller 13 may identify whether or not the temperature of the battery 12 is a first limit temperature or more which is a reference for blocking charging of the battery 12. When the temperature of the battery 12 is less than the first limit temperature, the controller 13 may control the battery 12 to be charged, on the basis of a preset charging current. The controller 13 may block charging of the battery 12 when the temperature of the battery 12 is the first limit temperature or more.

While the power of the aerosol generating device 1 is turned on, the controller 13 may identify whether or not the temperature of the battery 12 is a second limit temperature or more which is a reference for blocking discharge of the battery 12. The controller 13 may control power stored in the battery 12 to be used when the temperature of the battery 12 is less than the second limit temperature. When the temperature of the battery 12 is the second limit temperature or more, the controller 13 may stop using the power stored in the battery 12.

The controller 13 may calculate a remaining capacity of the power stored in the battery 12. For example, the controller 13 may calculate the remaining capacity of the battery 12 on the basis of a voltage and/or current sensing value of the battery 12.

The controller 13 may determine, through the insertion detection sensor 193, whether or not the stick is inserted into the insertion space. The controller 13 may determine that the stick is inserted, on the basis of the output signal of the insertion detection sensor 193. When determining that the stick is inserted into the insertion space, the controller 13 may control power to be supplied to the cartridge heater 15 and/or the heater 15. For example, the controller 13 may supply power to the cartridge heater 15 and/or the heater 15, on the basis of the temperature profile stored in the memory 60.

The controller 13 may determine whether or not the stick is removed from the insertion space. For example, the controller 13 may determine, through the insertion detection sensor 193, whether or not the stick is removed from the insertion space. For example, when the temperature of the heater 15 is the preset limit temperature or more or when a temperature change gradient of the heater 15 is a set gradient, the controller 13 may determine that the stick is removed from the insertion space. When determining that the stick is removed from the insertion space, the controller 13 may cut off the supply of power to the cartridge heater 15 and/or the heater 15.

The controller 13 may control a power supply time and/or a power supply amount with respect to the heater 15, according to a state of the stick detected by the sensor unit 19. The controller 13 may identify, on the basis of a look-up table, a level range including a level of a signal of the capacitance sensor. The controller 13 may determine an amount of moisture in the stick, according to the identified level range.

When the stick is over-humidified, the controller 13 may increase a preheating time of the stick compared to a normal state by controlling the power supply time with respect to the heater 15.

The controller 13 may determine, through the reuse detection sensor 194, whether or not the stick inserted into the insertion space is reused. For example, the controller 13 may compare a sensing value of a signal of the reuse detection sensor 194 with a first reference range including a first color and when the sensing value is included in the first reference range, determine that the stick is not used. For example, the controller 13 may compare the sensing value of the signal of the reuse detection sensor 194 with a second reference range including a second color and when the sensing value is included in the second reference range, determine that the stick is used. When determining that the stick is used, the controller 13 may cut off the supply of power to the cartridge heater 15 and/or the heater 15.

The controller 13 may determine, through the cartridge detection sensor 195, whether or not the cartridge 19 is coupled and/or removed. For example, the controller 13 may determine whether or not the cartridge 19 is coupled or removed, on the basis of a sensing value of the signal of the cartridge detection sensor 195.

The controller 13 may determine whether or not the aerosol generating material of the cartridge 19 is exhausted. For example, the controller 13 may apply power to preheat the cartridge heater 15 and/or the heater 15, determine whether or not the temperature of the cartridge heater 15 exceeds the limit temperature in a preheating period, and when the temperature of the cartridge heater 15 exceeds the limit temperature, determine that the aerosol generating material of the cartridge 19 is exhausted. When determining that the aerosol generating material of the cartridge 19 is exhausted, the controller 13 may cut off the supply of power to the cartridge heater 15 and/or the heater 15.

The controller 13 may determine whether or not the cartridge 19 may be usable. When the current number of puffs is greater than or equal to the maximum number of puffs set in the cartridge 19, the controller 13 may determine, on the basis of data stored in the memory 60, that the cartridge 19 may not be usable. For example, when the total time for which the heater 24 is heated is a preset maximum time or more or the total amount of power supplied to the heater 24 is a preset maximum amount of power or more, the controller 13 may determine that the cartridge 19 may not be usable.

The controller 13 may determine inhalation by the user through the puff sensor 192. For example, the controller 13 may determine whether or not a puff occurs, on the basis of a sensing value of a signal of the puff sensor 192. For example, the controller 13 may determine an intensity of the puff, on the basis of the sensing value of the signal of the puff sensor 192. When the number of puffs reaches the preset maximum number of puffs or when puffs are not detected for a preset time or more, the controller 13 may cut off the supply of power to the cartridge heater 15 and/or the heater 15.

The controller 13 may determine, through the cap detection sensor 196, whether a cap is coupled and/or removed. For example, the controller 13 may determine whether or not the cap is coupled and/or removed, on the basis of a sensing value of a signal of the cap detection sensor 196.

The controller 13 may control the output unit 40 on the basis of the result of detection by the sensor unit 19. For example, when the number of puffs counted through the puff sensor 192 reaches a preset number, the controller 13 may notify the user that the aerosol generating device 1 is soon terminated, through at least one of the display 41, the haptic unit 42, and the sound output unit 43. For example, the controller 13 may notify the user through the output unit 40 that the stick is not present in the insertion space, on the basis of the determination that the stick is not present in the insertion space. For example, the controller 13 may notify the user through the output unit 40 that the cartridge 19 and/or the cap are not mounted, on the basis of the determination that the cartridge 19 and/or the cap are not mounted. For example, the controller 13 may transmit information regarding the temperature of the cartridge heater 15 and/or the heater 15 to the user through the output unit 40.

The controller 13 may store and update, in the memory 60, a history of a certain event that occurs, on the basis of the occurrence of the event. The event may include detection of insertion of the stick, initiation of heating of the stick, detection of puffs, termination of the puffs, detection of overheating of the cartridge heater 15 and/or the heater 15, detection of application of an overvoltage to the cartridge heater 15 and/or the heater 15, termination of heating of the stick, an operation such as power on/off of the aerosol generating device 1, initiation of charging of the battery 12, detection of overcharging of the battery 12, termination of charging of the battery 12, and the like. The history of the event may include a date and time when the event occurs, log data corresponding to the event, and the like. For example, when the certain event is the detection of insertion of the stick, the log data corresponding to the event may include data regarding the sensing value of the insertion detection sensor 193 and the like. For example, when the certain event is the detection of overheating of the cartridge heater 15 and/or the heater 15, the log data corresponding to the event may include data regarding the temperature of the cartridge heater 15 and/or the heater 15, the voltage applied to the cartridge heater 15 and/or the heater 15, a current flowing through the cartridge heater 15 and/or the heater 15, and the like.

The controller 13 may control to form a communication link with an external device such as a mobile terminal of the user. When data regarding authentication is received from the external device through the communication link, the controller 13 may release a restriction on use of at least one function of the aerosol generating device 1. Here, the data regarding the authentication may include data indicating completion of user authentication for the user corresponding to the external device. The user may perform the user authentication through the external device. The external device may determine whether or not user data is valid, on the basis of the birthday of the user, a unique number indicating the user, and the like and receive, from an external server, data regarding use authority over the aerosol generating device 1. The external device may transmit the data indicating the completion of the user authentication to the aerosol generating device 1, on the basis of the data regarding the use authority. When the user authentication is completed, the controller 13 may release the restriction on the use of at least one function of the aerosol generating device 1. For example, when the user authentication is completed, the controller 13 may release a restriction on use of a heating function of supplying power to the heater 15.

The controller 13 may transmit data regarding the state of the aerosol generating device 1 to the external device through the communication link formed with the external device. On the basis of the received data regarding the state of the aerosol generating device 1, the external device may output the remaining capacity of the battery 12 of the aerosol generating device 1, an operation mode, and the like through a display of the external device.

The external device may transmit a location search request to the aerosol generating device 1, on the basis of an input for initiating a location search of the aerosol generating device 1. When receiving the location search request from the external device, the controller 13 may control at least one of output devices to perform an operation corresponding to the location search, on the basis of the received location search request. For example, the haptic unit 42 may generate vibration in response to the location search request. For example, the display 41 may output an object corresponding to the location search and an end of the search in response to the location search request.

When receiving firmware data from the external device, the controller 13 may control to perform a firmware update. The external device may identify a current version of firmware of the aerosol generating device 1 and determine whether or not a new version of the firmware is present. When an input for requesting firmware download is received, the external device may receive a new version of firmware data and transmit the new version of firmware data to the aerosol generating device 1. When receiving the new version of firmware data, the controller 13 may control the firmware update of the aerosol generating device 1 to be performed.

The controller 13 may transmit data regarding a sensing value of at least one sensor unit 19 to the external server (not shown) through the communicator 50, and receive from the server and store a learning model generated by learning the sensing value through machine learning such as deep learning. The controller 13 may perform an operation of determining an inhalation pattern of the user, an operation of generating a temperature profile, and the like by using the learning model received from the server. The controller 13 may store, in the memory 60, sensing value data of at least one sensor unit 19, data for training an artificial neural network (ANN), and the like. For example, the memory 60 may store a database for each component provided in the aerosol generating device 1, which is for training the ANN, and weights and biases constituting the structure of the ANN. The controller 13 may generate at least one learning model used for determining the inhalation pattern of the user, generating the temperature profile, and the like, by learning data regarding the sensing value of the at least one sensor unit 19, the inhalation pattern of the user, the temperature profile, and the like which are stored in the memory 60.

Some embodiments or other embodiments of the disclosure described above are not exclusive or distinct from each other. In some embodiments or other embodiments of the disclosure described above, respective components or functions may be used in combination with one another or combined with one another.

For example, a component A described in a particular embodiment and/or drawing and a component B described in another embodiment and/or drawing may be combined with each other. In other words, even when coupling between components is not directly described, the coupling may be made except when the coupling is described as impossible.

The above description should not be construed as being limited in all respects but should be considered illustrative. The scope of the disclosure should be determined by the logical interpretation of appended claims, and all changes within the equivalent scope of the disclosure are included in the scope of the disclosure.

## Claims

1. An aerosol-generating device comprising:
a housing including an accommodation space for accommodating an aerosol-generating article; and
a heater positioned inside the housing, and configured to heat an aerosol-generating article accommodated in the accommodation space when power is supplied,
wherein the heater comprises:
a polyimide film arranged to surround an aerosol-generating article accommodated in the accommodation space;
a conductive pattern arranged on the polyimide film and configured to generate heat when power is supplied; and
a sensing pad arranged so as not to overlap the conductive pattern, and configured to detect capacitance of the accommodation space.

2. The aerosol-generating device of claim 1, wherein the heater further comprises:
an inner sheet arranged in one area of the polyimide film in a state in which the polyimide film is unfolded; and
an outer sheet arranged in another area of the polyimide film spaced from the inner sheet, in the state in which the polyimide film is unfolded,
wherein the conductive pattern is arranged in an area between the inner sheet and the outer sheet of the polyimide film in the state in which the polyimide film is unfolded.

3. The aerosol-generating device of claim 2, wherein the sensing pad is arranged on the inner sheet or the outer sheet.

4. The aerosol-generating device of claim 3, wherein, when the polyimide film in the unfolded state is rolled up, the heater has a columnar shape with a cross-section of a circle or an ellipse so as to surround an outer surface of the aerosol-generating article, and
the conductive pattern and the sensing pad are arranged between the inner sheet and the outer sheet in a state in which the polyimide film is rolled up.

5. The aerosol-generating device of claim 1, wherein the heater further comprises a protective sheet surrounding an outer surface of the polyimide film and configured to protect the polyimide film,
wherein the sensing pad is arranged on the protective sheet so as not to overlap the conductive pattern.

6. The aerosol-generating device of claim 1, further comprising a processor electrically connected to the sensing pad.

7. The aerosol-generating device of claim 6, further comprising:
a printed circuit board arranged inside the housing, wherein the processor is arranged on at least one area of the printed circuit board; and
an electrical connection member electrically connecting the heater to the printed circuit board,
wherein the processor is electrically connected to the sensing pad through the electrical connection member.

8. The aerosol-generating device of claim 6, wherein the processor is configured to:
detect whether the aerosol-generating article is accommodated in the accommodation space, based on a capacitance value of the accommodation space detected through the sensing pad.

9. The aerosol-generating device of claim 6, wherein the processor is configured to:
detect whether the aerosol-generating article accommodated in the accommodation space is in an over-moisture state, based on a capacitance value of the accommodation space detected through the sensing pad.

10. The aerosol-generating device of claim 9, wherein the processor is further configured to:
control the power supplied to the heater, based on whether the aerosol-generating article accommodated in the accommodation space is in the over-moisture state.

11. The aerosol-generating device of claim 6, wherein the sensing pad comprises:
a first sensing pad; and
a second sensing pad spaced apart from the first sensing pad,
wherein the processor is configured to:
detect whether the aerosol-generating article is accommodated in the accommodation space, based on a difference between a capacitance value of the accommodation space detected through the first sensing pad and a capacitance value of the accommodation space detected through the second sensing pad.

12. The aerosol-generating device of claim 1, further comprising:
an upper fixing member positioned inside the housing to fix one end of the heater; and
a lower fixing member positioned inside the housing to fix the other end of the heater positioned in an opposite direction to the one end.

13. The aerosol-generating device of claim 12, further comprising an insulating member arranged to surround an outer surface of the heater, and configured to block heat generated from the heater from being transferred to the housing.
